# EUROPEAN PATENT APPLICATION

(11) **EP 2 699 055 A2**
(43) Date of publication of application: **19.02.2014**
(21) Application number: 12182493.2
(22) Date of filing: 30.08.2012
(51) Int. Cl.: H05B 33/08, F21S 2/00, F21V 23/00, H01L 25/075

(54) **Light-emitting module and luminaire**

(30) Priority: 31.05.2012 JP 2012125323
(71) Applicant: Toshiba Lighting & Technology Corporation, Yokosuka-shi Kanagawa 237-8510 (JP)
(72) Inventor: Oyaizu, Tsuyoshi, Kanagawa, 237-8510 (JP)
(74) Representative: Willquist, Sofia Ellinor

(57) **Abstract**

A light-emitting module (10a-10c) includes a first light-emitting element group which includes first light-emitting elements (2a) and in which the plural first light-emitting elements are connected in series. Besides, the light-emitting module includes a second light-emitting element group which includes second light-emitting elements (4a) whose rate of change of light-emitting efficiency and rate of change of voltage with respect to a temperature change are large as compared with the first light-emitting elements, in which the plural second light-emitting elements are connected in series, and which is connected in parallel to the first light-emitting element group.

## Description

### FIELD

Embodiments described herein relate generally to a light-emitting module and a luminaire.

### BACKGROUND

Recently, as a luminaire, a luminaire including a power-saving light-emitting element such as an LED (Light Emitting Diode) is used. In the luminaire including the light-emitting element, as compared with, for example, a related art incandescent lamp, higher brightness or illuminance can be obtained with less power consumption.

Here, in the luminaire including the light-emitting element, plural kinds of light-emitting elements different in light-emitting color are often mounted in a light-emitting module. In this case, the light outputted from the luminaire becomes the light in which lights outputted from the respective plural kinds of light-emitting elements mounted in the light-emitting module are mixed. In other words, the light-emitting color of the light emitted from the luminaire is the color in which the light-emitting colors of the respective plural kinds of light-emitting elements are mixed.

### DESCRIPTION OF THE DRAWINGS

FIG. 1 is a vertical sectional view showing a luminaire in which a light-emitting module of a first embodiment is mounted.
FIG. 2 is a top view showing the light-emitting module of the first embodiment.
FIG. 3 is a cross-sectional view showing the luminaire in which the light-emitting module of the first embodiment is mounted.
FIG. 4 is a view showing an electric wiring of the light-emitting module of the first embodiment.
FIG. 5 is a view showing reflection in the light-emitting colors of respective light-emitting elements of the light-emitting module of the first embodiment.
FIG. 6 is a view showing an example of a relation between temperature and light-emitting efficiency in light-emitting elements.
FIG. 7 is a view showing an example of a relation between driving voltage and temperature in the light-emitting elements.
FIG. 8 is a view showing an example of a circuit diagram of a case where red LEDs and blue LEDs are connected in parallel.
FIG. 9 is a view showing an example of a circuit diagram of a case where red LEDs and blue LEDs are connected in series.
FIG. 10 is a view showing an example of a relation between temperature and color temperature in the circuit diagram shown in FIG. 8 and the circuit diagram shown in FIG. 9.
FIG. 11 is a top view showing a light-emitting module of a second embodiment.
FIG. 12 is a top view showing a light-emitting module of a third embodiment.

### DETAILED DESCRIPTION

According to one embodiment, a light-emitting module includes a first light-emitting element group, and a second light-emitting element group.

The first light-emitting element group is configured to include first light-emitting elements which are connected in series. The second light-emitting element group configured to include second light-emitting elements which are connected in series and connected in parallel to the first light-emitting element group. Rate of change of light-emitting efficiency and rate of change of voltage with respect to a temperature change of the second light-emitting elements are large as compared with the first light-emitting elements.

Hereinafter, the light-emitting module and a luminaire according to embodiments will be described with reference to the drawings. In the embodiments, components having the same function are denoted by the same reference numerals and a duplicate description thereof will be omitted. Incidentally, light-emitting modules and luminaires described in the following embodiments are merely examples and do not limit the invention. Besides, the following embodiments may be appropriately combined within a consistent range.

In general, according to one embodiment, a light-emitting module 10a-10c includes, for example, a first light-emitting element group which includes first light-emitting elements and in which the plural first light-emitting elements are connected in series. Besides, the light-emitting module 10a-10c includes, for example, a second light-emitting element group which includes second light-emitting elements whose rate of change of light-emitting efficiency and rate of change of voltage with respect to a temperature change are large as compared with the first light-emitting elements, in which the plural second light-emitting elements are connected in series, and which is connected in parallel to the first light-emitting element group.

Besides, in the light-emitting module 10a-10c, for example, the first light-emitting element group and the second light-emitting element group connected in parallel are connected to a common power supply path. Here, even when the total amount of power supplied to the respective light-emitting element groups at lighting is not changed, when temperatures of the respective light-emitting elements of the respective light-emitting element groups are changed by the lighting, values of currents flowing through the respective light-emitting element groups are changed.

Besides, in the light-emitting module 10a-10c, for example, the light-emitting efficiency and the voltage of the first light-emitting element and the second light-emitting element decrease with rise of the temperature, and increase with lowering of the temperature.

Besides, in the light-emitting module 10a-10c, for example, the first light-emitting element is a blue LED (Light Emitting Diode) element, and the second light-emitting element is a red LED element.

Besides, in the light-emitting module 10a-10c, for example, the first light-emitting element group in which the plural first light-emitting elements are connected in series is connected in parallel to the second light-emitting element group in which the plural second light-emitting elements are connected in series. Besides, a rated condition of the first light-emitting element group is equal to a rated condition of the second light-emitting element group. The rated condition is, for example, a rated current of the light-emitting element group, a rated voltage of the light-emitting element group or a combination thereof.

Besides, the light-emitting module 10a-10c includes, for example, plural first light-emitting element groups and plural second light-emitting element groups. Besides, the plural first light-emitting element groups and the plural second light-emitting element groups are connected in parallel.

Besides, according to another embodiment, a luminaire 100a-100c includes, for example, a light-emitting module 10a-10c, and a lighting device to supply power to the light-emitting module 10a-10c.

Incidentally, in the following embodiments, although a description will be made under assumption that a light-emitting element is an LED (Light Emitting Diode), no limitation is made to this. For example, an organic EL (OLEDs (Organic Light Emitting Diodes)) may be adopted, or another light-emitting element to emit a specific color light by current supply, such as a semiconductor laser, may be adopted.

Besides, in the following embodiments, although a description is made while using, as an example, a case where the first light-emitting element is a blue LED (Light Emitting Diode) element and the second light-emitting element is a red LED element, no limitation is made to this. That is, the second light-emitting element may be any light-emitting element as long as the element is connected in parallel to the first light-emitting element, and the rate of change of light-emitting efficiency and the rate of change of voltage with respect to the temperature change are large as compared with the first light-emitting element. For example, both the first light-emitting element and the second light-emitting element may be light-emitting elements to emit blue light, or may be any light-emitting element.

Besides, in the following embodiments, the LED includes a light-emitting diode chip made of a gallium nitride (GaN) semiconductor in which light-emitting color is blue or a quaternary material (Al/In/Ga/P) compound semiconductor in which light-emitting color is red. Besides, the LEDs are mounted into a form, such as a matrix form, a staggered form or a radiation form, in which a part or all of the LEDs are arranged regularly and at constant interval by using, for example, a COB (Chip On Board) technique. Alternatively, the LED may include, for example, a SMD (Surface Mount device). Besides, in the following embodiments, the LED group includes the same kind of LEDS and the number of the LEDs can be changed according to the use of illumination.

Besides, in the following embodiments, although the luminaire is of a krypton bulb type, no limitation is made to this, and a general bulb type, a bullet type or the like may be adopted.

### First Embodiment

### Structure of Luminaire in Which Light-Emitting Module of the First Embodiment Is Mounted

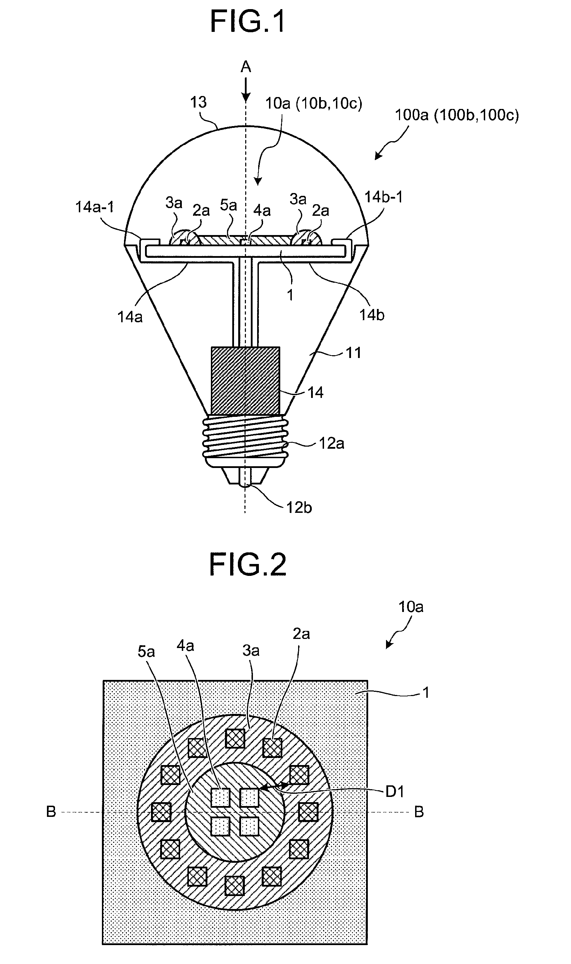

FIG. 1 is a vertical sectional view showing a luminaire in which a light-emitting module of a first embodiment is mounted. As shown in FIG. 1, a luminaire 100a of the first embodiment includes a light-emitting module 10a. Besides, the luminaire 100a includes a main body 11, a cap member 12a, an eyelet part 12b, a cover 13, a control part 14, an electric wiring 14a, an electrode junction part 14a-1, an electric wiring 14b, and an electrode junction part 14b-1.

The light-emitting module 10a is arranged on an upper surface of the main body 11 in the vertical direction. The light-emitting module 10a includes a substrate 1. The substrate 1 is made of a low-heat conductivity ceramic, for example, alumina. The heat conductivity of the substrate 1 is, for example, 33 W/m•K at 300K and under air atmosphere.

When the substrate 1 is made of the ceramic, since the mechanical strength and the size accuracy are high, the yield at the time of mass production of the light-emitting module 10 is improved, the manufacturing cost of the light-emitting module 10a is reduced, and the life of the light-emitting module 10a is lengthened. Besides, since the ceramic has a high reflectivity to visible light, the light-emitting efficiency of the LED module is improved.

Incidentally, the substrate 1 may be made of silicon nitride, silicon oxide or the like instead of alumina. The heat conductivity of the substrate 1 is preferably 20 to 70 W/m•K. When the heat conductivity of the substrate 1 is 20 to 70 W/m•K, the manufacturing cost, reflectivity and heat influence between light-emitting elements mounted on the substrate 1 can be suppressed. Besides, in the substrate 1 made of the ceramic having the preferable heat conductivity, as compared with a substrate having a high heat conductivity, the heat influence between the light-emitting elements mounted on the substrate 1 can be suppressed. Thus, in the substrate 1 made of the ceramic having the preferable heat conductivity, a separate distance between the light-emitting elements mounted on the substrate 1 can be shortened, and further miniaturizing can be achieved.

Incidentally, the substrate 1 may be made of nitride of aluminum such as aluminum nitride. In this case, the heat conductivity of the substrate 1 is lower than, for example, 225 W/m•K, which is the heat conductivity of aluminum of about 99.5 mass%, at 300K and under the air atmosphere.

In the light-emitting module 10a, for example, blue LEDs 2a are arranged on the circumference of the upper surface of the substrate 1 in the vertical direction. Besides, in the light-emitting module 10a, for example, red LEDs 4a are arranged in the vicinity of the center of the upper surface of the substrate 1 in the vertical direction. As compared with the blue LED 2a, in the red LED 4a, the light-emitting amount of the light-emitting element further decreases as the temperature of the light-emitting element rises. That is, the red LED 4a is inferior to the blue LED 2a in that the light-emitting amount of the light-emitting element further decreases as the temperature of the light-emitting element rises. In the first embodiment, since the substrate 1 is made of the low-heat conductivity ceramic, heat generated by the blue LED 2a is prevented from being transmitted to the red LED 4a through the substrate 1, and the deterioration of the light-emitting efficiency of the red LED 4a is suppressed.

Incidentally, in FIG. 1, the number of the blue LEDs 2a and the red LEDs 4a is omitted. That is, as a first light-emitting element group, the plural blue LEDs 2a are arranged on the circumference of the upper surface of the substrate 1 in the vertical direction. Besides, as a second light-emitting element group, the plural red LEDs 4a are arranged in the vicinity of the center of the upper surface of the substrate 1 in the vertical direction.

The first light-emitting element group including the plural blue LEDs 2a is covered with a sealing part 3a from above. The sealing part 3a on the upper surface of the substrate 1 in the vertical direction has a substantially semicircular or substantially trapezoidal section, and is formed into an annular shape so as to cover the plural blue LEDs 2a. Besides, the second light-emitting element group including the plural red LEDs 4a, together with a recess formed of an annular inside surface of the sealing part 3a and the substrate 1, is covered with a sealing part 5a from above.

The sealing part 3a and the sealing part 5a can be made of various resins such as epoxy resin, urea resin and silicone resin. The sealing part 5a may be a transparent resin which does not contain phosphor and has a high diffusion property. The sealing part 3a and the sealing part 5a are made of different kinds of resin. The light refractive index n1 of the sealing part 3a, the light refractive index n2 of the sealing part 5a, and the light refractive index n3 of a gas sealed in the space formed of the main body 11 and the cover 13 have a relation of, for example, n3 < n1 < n2. Hereinafter, the gas sealed in the space formed of the main body 11 and the cover 13 is called "sealed gas". The sealed gas is, for example, the air.

Besides, in the light-emitting module 10a, an after-mentioned electrode 6a-1 is connected to an electrode junction part 14a-1. Besides, in the light-emitting module 10a, an after-mentioned electrode 8a-1 is connected to an electrode junction part 14b-1.

The main body 11 is made of a metal having excellent heat conductivity, for example, aluminum. The main body 11 has a cylindrical shape whose cross-sectional surface is substantially circular, the cover 13 is attached to one end thereof, and the cap member 12a is attached to the other end. Besides, the main body 11 is formed such that the outer peripheral surface is made a conical taper surface whose diameter sequentially becomes small from one end to the other end. The main body 11 is formed such that the outer appearance has a shape close to a silhouette of a neck part of a mini krypton bulb. In the main body 11, not-shown many thermal radiation fins protruding radially from one end to the other end are integrally formed on the outer peripheral surface.

The cap member 12a is, for example, an Edison type E-type cap, and includes a tubular shell made of copper and having threads, and the conductive eyelet part 12b provided at the top of the lower end of the shell through an electrical insulation part. The opening of the shell is electrically insulated from and fixed to the opening of the other end of the main body 11. The shell and the eyelet part 12b are connected with a not-shown input line extracted from a power input terminal of a not-shown circuit board in the control part 14.

The cover 13 forms a globe, and is formed into, for example, a smooth curved surface shape close to the silhouette of a mini krypton bulb made of milky white polycarbonate and having an opening at one end. The cover 13 is fixed such that the opening end is fitted in the main body 11 so as to cover the light-emitting surface of the light-emitting module 10a. By this, the luminaire 100a is constructed as a lamp with a cap, which includes the globe as the cover 13 at one end, and the E-type cap member 12a at the other end, the whole outer appearance shape of which is close to the silhouette of the mini krypton bulb, and which can replace the mini krypton bulb. Incidentally, the method of fixing the cover 13 to the main body 11 may be any one of adhering, fitting, screwing and locking.

The control part 14 contains a not-shown lighting device to control lighting of the blue LEDs 2a and the red LEDs 4a mounted on the substrate 1 and electrically insulates the device from the outside. The control part 14 converts AC voltage into DC voltage and supplies the voltage to the blue LEDs 2a and the red LEDs 4a. Besides, in the control part 14, the electric wiring 14a for supplying power to the blue LEDs 2a and the red LEDs 4a is connected to the output terminal of the lighting device. Besides, in the control part 14, the second electric wiring 14b is connected to the input terminal of the lighting device. The electric wiring 14a and the electric wiring 14b are insulated and coated.

Here, the lighting device supplies power to the light-emitting module 10a-10c. Here, the first light-emitting element group and the second light-emitting element group connected in parallel in the light-emitting module 10a-10c are connected to the lighting device through a common power supply path. The total amount of power supplied to the respective light-emitting element groups by the lighting device does not change even if temperature change occurs in the respective light-emitting element groups at lighting. Besides, the values of currents flowing through the respective light-emitting element groups by the lighting device change when the temperature change occurs in the respective light-emitting element groups at the lighting.

The electric wiring 14a is extracted to the opening at one end of the main body 11 through a not-shown through-hole and a not-shown guide groove formed in the main body 11. The electrode junction part 14a-1 of the electric wiring 14a, which is a tip portion and in which the insulating coating is peeled, is joined to the electrode 6a-1 of the wiring arranged on the substrate 1. The electrode 6a-1 will be described later.

Besides, the electric wiring 14b is extracted to the opening at one end of the main body 11 through a not-shown through-hole and a not-shown guide groove formed in the main body 11. The electrode junction part 14b-1 of the electric wiring 14b, which is a tip portion and in which the insulating coating is peeled, is joined to the electrode 8a-1 of the wiring arranged on the substrate 1. The electrode 8a-1 will be described later.

In this way, the control part 14 supplies the power inputted through the shell and the eyelet part 12b to the blue LEDs 2a and the red LEDs 4a through the electric wiring 14a. Then, the control part 14 collects the power supplied to the blue LEDs 2a and the red LED 4a through the electric wiring 14b.

### Structure of the Light-emitting Module of the First Embodiment

FIG. 2 is a top view showing the light-emitting module of the first embodiment. FIG. 2 is the top view of the light-emitting module 10a when viewed from an arrow A direction in FIG. 1. As shown in FIG. 2, the first light-emitting element group including the plural blue LEDs 2a is arranged annularly and regularly on the circumference of the center of the substantially rectangular substrate 1. The first light-emitting element group including the plural blue LEDs 2a is annularly and fully covered with the sealing part 3a. An area of the substrate 1 covered with the sealing part 3a is called a first area.

Besides, as shown in FIG. 2, the second light-emitting element group including the plural red LEDs 4a is arranged in a lattice form and regularly in the vicinity of the center of the substantially rectangular substrate 1. The LED group including the plural red LEDs 4a is fully covered with the sealing part 5a. Besides, the sealing part 5a fully covers the inside of the annular ring of the first area. In the substrate 1, an area covered with the sealing part 5a is called a second area.

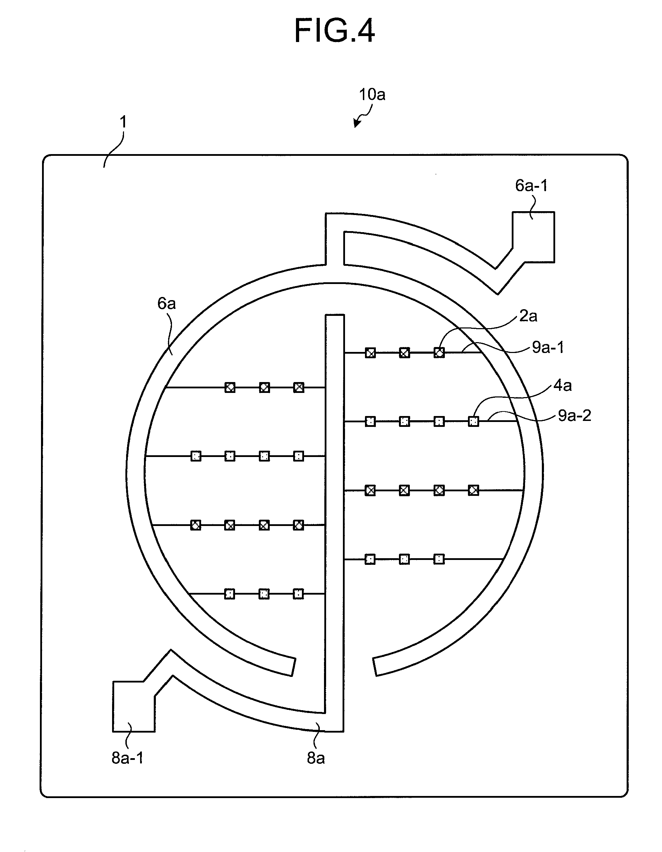

Incidentally, since the details of the connection state of the blue LEDs 2a and the red LEDs 4a will be described later with reference to FIG. 4, the description thereof is omitted here.

As shown in FIG. 2, the shortest distance of distances between the blue LEDs 2a and the red LEDs 4a is called a distance D1 between the blue LED 2a and the red LED 4a. Incidentally, the distance between the blue LED 2a and the red LED 4a is not limited to the shortest distance of the distances between the blue LEDs 2a and the red LEDs 4a, but may be a distance between the center position of the first light-emitting element group and the center position of the second light-emitting element group. In the example shown in FIG. 2, for example, the center position of the first light-emitting element group is a circumference passing through the respective centers of the blue LEDs 2a arranged annularly. Besides, for example, the center position of the second light-emitting element group is the center of the arrangement in which the red LEDs 4a are arranged in the lattice form. In this case, the distance between the blue LED 2a and the red LED 4a is a distance between the center of the arrangement in which the red LEDs 4a are arranged in the lattice form and one point on the circumference passing through the respective centers of the blue LEDs 2a arranged annularly.

In the light-emitting module 10a, even if the plural kinds of LEDs significantly different in thermal characteristics are mixedly mounted on the ceramic substrate 1 while the areas are separated according to the kinds of the LEDs, the influence of heat generated by the blue LEDs 2a exerted on the red LEDs 4a is suppressed. Thus, in the light-emitting module 10, a desired light-emitting characteristic is easily obtained.

Besides, in the light-emitting module 10a, for example, the blue LEDs 2a and the red LEDs 4a are arranged in the separate areas. Thus, in the light-emitting module 10a, for example, since the heat generated by the blue LEDs 2a is suppressed to be conducted to the red LEDs 4a, the whole thermal characteristics of the light-emitting module 10a are improved.

Incidentally, in FIG. 2, the numbers and the positions of the blue LEDs 2a and the red LEDs 4a are merely examples, and an arbitrarily arrangement may be adopted.

### Details of Mounting of the Light-Emitting Module of the First Embodiment

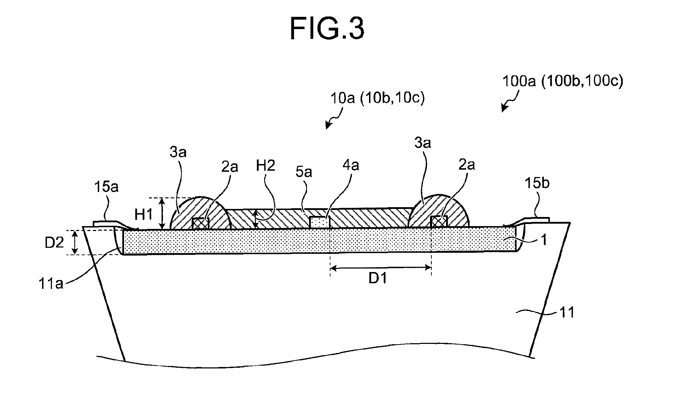

FIG. 3 is a cross-sectional view showing a luminaire in which the light-emitting module of the first embodiment is mounted. FIG. 3 is a B-B sectional view of the light-emitting module 10a of FIG. 2. In FIG. 3, the cover 13 of the luminaire 100a and the lower part of the main body 11 are not shown. As shown in FIG. 3, the main body 11 of the luminaire 100a includes a recess 11a to receive the substrate 1 of the light-emitting module 10a, a fixing member 15a and a fixing member 15b to fix the substrate 1. In the light-emitting module 10a, the substrate 1 is received in the recess 11a of the main body 11.

The edge of the substrate 1 is pressed downward to the recess 11a by the pressing force of the fixing member 15a and the fixing member 15b, so that the light-emitting module 10a is fixed to the main body 11. By this, the light-emitting module 10a is attached to the luminaire 100a. Incidentally, the method of attaching the light-emitting module 10a to the luminaire 100a is not limited to the method shown in FIG. 3, and any method such as adhering, fitting, screwing or locking may be used.

As shown in FIG. 3, the distance D1 between the blue LED 2a and the red LED 4a is longer than a thickness D2 of the substrate 1 in the vertical direction. The heat generated by light-emission of the blue LEDs 2a and the red LEDs 4a is more easily conducted in the horizontal direction than in the vertical direction in the substrate 1. Thus, for example, the heat generated by the blue LED 2a is conducted to the red LED 4a in the horizontal direction of the substrate 1, and the light-emitting efficiency of the red LED 4a is further deteriorated. However, the distance D1 between the blue LED 2a and the red LED 4a is made longer than the thickness D2 of the substrate 1 in the vertical direction, so that the heat generated by the blue LED 2a is suppressed from being conducted to the red LED 4a in the horizontal direction of the substrate 1. Thus, deterioration of the light-emitting efficiency of the red LED 4a is suppressed. However, no limitation is made to this, and the distance D1 may be an arbitrary value.

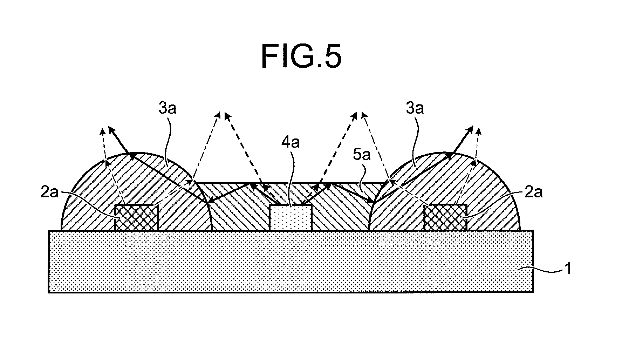

Besides, as shown in FIG. 3, a height H1 of the sealing part 3a is higher than a height H2 of the sealing part 5a. This effect will be described later with reference to FIG. 5. Incidentally, the height H1 of the sealing part 3a and the height H2 of the sealing part 5a may be equal to each other.

### Wiring of the Light-Emitting Module of the First Embodiment

FIG. 4 is a view showing an electric wiring of the light-emitting module of the first embodiment. As shown in FIG. 4, the light-emitting module 10a includes a first light-emitting element, and a second light-emitting element which is connected in parallel to the first light-emitting element and whose rate of change of light-emitting efficiency and rate of change of voltage with respect to a temperature change are large as compared with the first light-emitting element. Specifically, a first light-emitting element group in which the plural first light-emitting elements are connected in series and a second light-emitting element group in which the plural second light-emitting elements are connected in series are connected in parallel. Besides, there are plural first light-emitting element groups and plural second light-emitting element groups, and the plural first light-emitting element groups and the plural second light-emitting element groups are connected in parallel. Besides, the first light-emitting element groups and the second light-emitting element groups connected in parallel are connected to a common power supply path.

In the example shown in FIG. 4, the light-emitting module 10a includes, on the substrate 1, the electrode 6a-1 connected to the electrode junction part 14a-1 of the luminaire 100a, and a wiring 6a extending from the electrode 6a-1. Besides, the light-emitting module 10a includes, on the substrate 1, the electrode 8a-1 connected to the electrode junction part 14b-1 of the luminaire 100a, and a wiring 8a extending from the electrode 8a-1.

Here, in the light-emitting module 10a, on the substrate 1, the plural blue LEDs 2a connected in series by a bonding wire 9a-1 are connected to the wiring 6a and the wiring 8a. Besides, in the light-emitting module 10a, on the substrate 1, the plural red LEDs 4a connected in series by a bonding wire 9a-2 are connected to the wiring 6a and the wiring 8a. As a result, the plural blue LEDs 2a connected in series by the bonding wire 9a-1 and the plural red LEDs 4a connected in series by the bonding wire 9a-2 are connected in parallel.

As stated above, the plural blue LEDs 2a and the plural red LEDs 4a connected in series by the bonding wire 9a-1 and the bonding wire 9a-2 are connected in parallel, so that the amounts of currents flowing through the respective blue LEDs 2a and the respective red LEDs 4a are changed in accordance with the temperature change of the light-emitting element, and the change of the output balance of lights outputted by the plural kinds of light-emitting elements can be suppressed. The details of the reason why the change of the light output balance can be suppressed will be described later.

### Reflection of Light-Emitting Colors of the Respective Light-Emitting Elements of the First Embodiment

FIG. 5 is a view showing reflection in the light-emitting colors of the respective light-emitting elements of the light-emitting module of the first embodiment. As a premise in FIG. 5, as stated above, the light refractive index n1 of the sealing part 3a, the light refractive index n2 of the sealing part 5a, and the light refractive index n3 of the gas sealed in the space formed of the main body 11 and the cover 13 have a relation of n3 < n1 < n2.

As indicated by a solid line arrow in FIG. 5, the light emitted by the red LED 4a is almost totally reflected at the interface between the sealing part 5a and the sealing gas due to the relation of the refractive index and travels in the direction toward the sealing part 3a. Besides, as indicated by the solid line arrow in FIG. 5, the light reflected at the interface between the sealing part 5a and the sealing gas and traveling in the direction toward the sealing part 3a is refracted at the interface between the sealing part 5a and the sealing part 3a due to the relation of the refractive index and travels to the inside of the sealing part 3a.

On the other hand, the light emitted by the blue LED 2a is refracted at the interface between the sealing part 3a and the sealing gas due to the relation of the refractive index as indicated by a two-dot chain line in FIG. 5 and travels in the direction toward the sealing gas. Incidentally, most of the light emitted by the blue LED 2a is reflected at the interface between the sealing part 3a and the sealing part 5a due to the relation of the refractive index. Besides, the height H1 of the sealing part 3a is higher than the height H2 of the sealing part 5a. Thus, the area of the interface between the sealing part 3a and the sealing part 5a is decreased, and the area of the interface between the sealing part 3a and the sealing gas can be increased.

In this way, as shown in FIG. 5, since most of the lights emitted by the blue LED 2a and the red LED 4a are suitably combined in the vicinity of the interface between the sealing part 3a and the sealing gas and are emitted, the uniformity of light-emission can be enhanced. Besides, in the light-emitting module 10a, since the light emitted by the red LED 4a is efficiently extracted and is efficiently combined with the light emitted by the blue LED 2a, the number of the mounted red LEDs 4a can be reduced. Thus, in the light-emitting module 10a, the deterioration of the whole light-emitting characteristic due to the deterioration of the light-emitting characteristic of the red LED 4a due to the heat is suppressed.

Besides, in FIG. 5, as indicated by a broken line arrow, part of the light emitted by red LED 4a is not reflected at the interface between the sealing part 5a and the sealing gas, but is refracted and travels in the direction toward the sealing gas above the sealing part 5a. On the other hand, as indicated by an alternate long and short dash line in FIG. 5, part of the light emitted by the blue LED 2a is refracted at the interface between the sealing part 3a and the sealing gas, and travels in the direction toward the sealing gas above the sealing part 5a. In this way, even if part of the light emitted by the red LED 4a outgoes upward from the sealing part 5a, since the height of the sealing part 3a is higher than the height of the sealing part 5a, the light of the blue LED 2a outgoing from the upper area of the sealing part 3a on the sealing part 5a side and the light of the red LED 4a outgoing from the sealing part 5a are more uniformly mixed. Accordingly, even if the LEDs having different light-emitting colors are provided in the separate areas, irregular color in color mixture is more suppressed.

In the light-emitting module 10a, for example, the second area where the red LEDs 4a having a small light-emitting amount are arranged is sealed with the transparent resin not containing phosphor, so that light absorption by phosphor can be avoided, and the light-emitting efficiency is improved. Besides, in the light-emitting module 10a, when the second area where a specified number of red LEDs are arranged is sealed with the transparent resin having a high diffusion property, the red light is effectively diffused, and therefore, irregular color of the LED module is suppressed. That is, the light-emitting module 10a can reduce the deterioration of color rendering properties of the emitted light and light-emitting efficiency.

Incidentally, in the first embodiment, the blue LEDs 2a are annularly arranged on the substrate 1, and the red LEDs 4a are arranged in the vicinity of the center of the annular shape. However, no limitation is made to the annular shape, and any shape, such as a rectangle or a rhombus, may be adopted as long as the shape is annular.

Besides, in the first embodiment, the description is made while using, as an example, the case where the plural first light-emitting element groups and the plural second light-emitting element groups exist, and the plural first light-emitting element groups and the plural second light-emitting element groups are connected in parallel. In other words, the case where the plural red LEDs 4a connected in series by the bonding wire 9a-2 and the plural blue LEDs 2a connected in series by the bonding wire 9a-1 are connected in parallel is exemplified. However, no limitation is made to this. For example, the first light-emitting element and the second light-emitting element may be connected in parallel. In other words, one blue LED 2a and one red LED 4a may be connected in parallel. Besides, for example, one first light-emitting element group and one second light-emitting element group may be connected in parallel, one first light emitting element group and plural second light-emitting element groups may be connected in parallel, or plural first light-emitting element groups and one second light-emitting element group may be connected in parallel.

### Effect of the First Embodiment

According to the first embodiment, the light-emitting module includes the first light-emitting elements, and includes the first light-emitting element group in which the first light-emitting elements are connected in series. Besides, the light-emitting module includes the second light-emitting elements whose rate of change of light-emitting efficiency and rate of change of voltage with respect to the temperature change are large as compared with the first light-emitting elements, and includes the second light-emitting element group in which the plural second light-emitting elements are connected in series and which is connected in parallel to the first light-emitting element group. As a result, the change of the output balance of the lights outputted by the respective plural kinds of light-emitting elements can be suppressed.

Besides, according to the first embodiment, the first light-emitting element group and the second light-emitting element group connected in parallel are connected to the common power supply path. Even when the total power amount supplied to the respective light-emitting element groups at lighting is not changed, when the respective light-emitting elements of the respective light-emitting element groups are temperature-changed by the lighting, the values of currents flowing through the respective light-emitting element groups are changed. As a result, the change of the output balance of the lights outputted by the plural kinds of light-emitting elements can be suppressed.

That is, according to the first embodiment, in the light-emitting module, the change characteristics of both the light-emitting efficiency and the voltage of one of the plural kinds of light-emitting elements with respect to the drive temperature are steep as compared with the other, and the respective kinds of light-emitting element groups are electrically arranged in parallel. Here, when the drive temperature rises, the light-emitting efficiency of a light-emitting element is significantly reduced, and at the same time, the driving voltage thereof is also significantly reduced. Thus, the current amount increases relative to the other kind of light-emitting element. As a result, the change of the balance of the outputs of the respective kinds of LED elements due to the change of the drive condition and the environment can be suppressed.

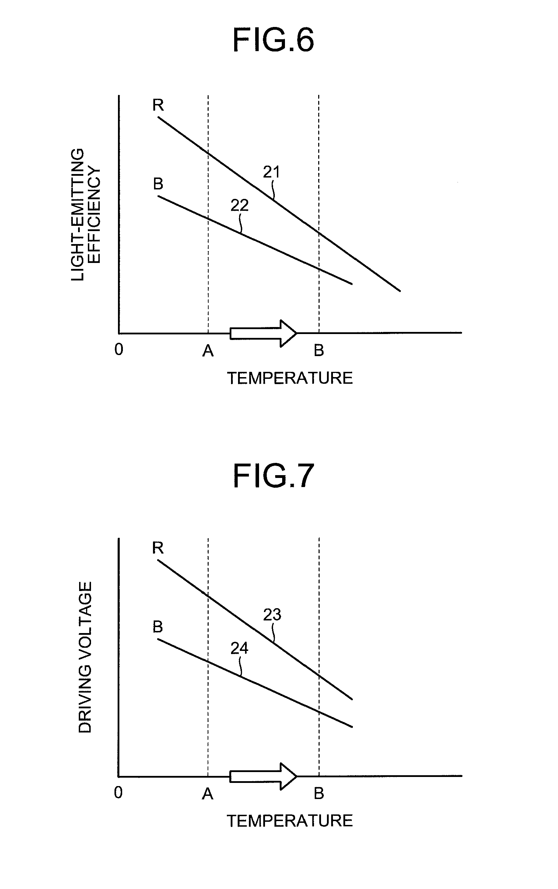

FIG. 6 is a view showing an example of a relation between temperature and light-emitting efficiency in light-emitting elements. FIG. 7 is a view showing an example of a relation between driving voltage and temperature in the light-emitting elements. R21 of FIG. 6 and R23 of FIG. 7 denote values of a red LED, and B22 of FIG. 6 and B24 of FIG. 7 denote values of a blue LED. As shown in FIG. 6 and FIG. 7, as compared with the blue LED, the rate of change of the light-emitting efficiency and the rate of change of the driving voltage of the red LED with respect to the temperature change are large.

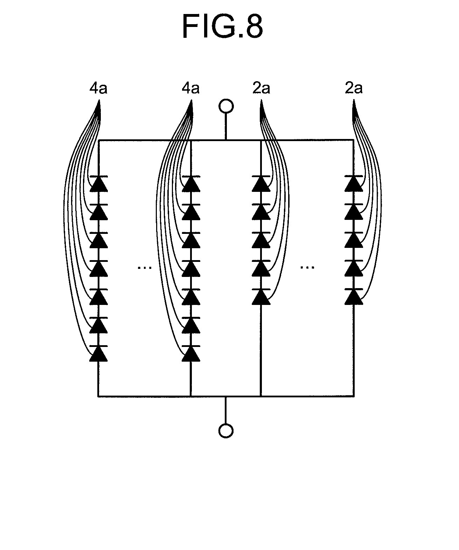

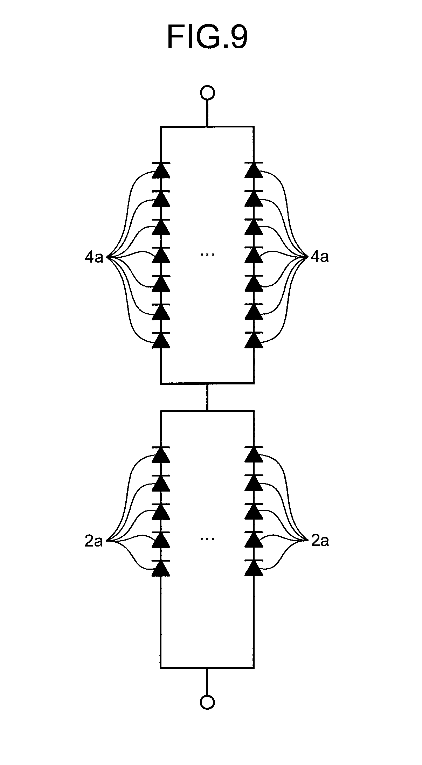

FIG. 8 is a view showing an example of a circuit diagram of a case where the red LEDs and the blue LEDs are connected in parallel. FIG. 9 is a view showing an example of a circuit diagram of a case where the red LEDs and the blue LEDs are connected in series. In the examples shown in FIG. 8 and FIG. 9, the plural red LEDs 4a are connected in series, and the plural blue LEDs 2a are connected in series. Besides, the examples include the plural groups of the plural red LEDs 4a connected in series, and the plural groups of the plural blue LEDs 2a connected in series. Besides, in the example shown in FIG. 9, the plural groups of the blue LEDs 2a are connected in parallel, the plural groups of the red LEDs 4a are connected in parallel, and the plural groups of the blue LEDs 2a connected in parallel and the plural groups of the red LEDs 4a connected in parallel are connected in series. Here, in the circuit diagram shown in FIG. 8, similarly to the light-emitting module of the first embodiment, the red LEDs 4a and the blue LEDs 2a are connected in parallel. The circuit diagram shown in FIG. 9 is a circuit diagram shown for comparison.

Here, the reason why the change of the output balance of lights outputted by the respective plural kinds of light-emitting elements can be suppressed will be described while using, as an example, a case where temperature rises with reference to Fig. 6 to Fig. 9. When the temperature rises, as shown in FIG. 6, the light-emitting efficiency of the red LED 4a is significantly reduced as compared with the light-emitting efficiency of the blue LED 2a. As a result, this means that the ratio of the red LED 4a in the light outputted from the light-emitting module becomes small as compared with the case before the rise of temperature. That is, the output balance of the light is changed.

When the temperature rises, as shown in FIG. 7, the driving voltage of the red LED 4a is significantly reduced as compared with the driving voltage of the blue LED 2a. Besides, as shown in FIG. 8, when the red LED 4a and the blue LED 2a are connected in parallel, the same power is supplied to the red LED 4a and the blue LED 2a. Besides, the power is represented by voltage × current. As a result, in the red LED 4a in which the driving voltage is significantly reduced as compared with the blue LED 2a, a relatively large current as compared with the case before the rise of temperature flows by the large reduction of the driving voltage as compared with the blue LED 2a. Then, as a result that the current flowing through the red LED 4a becomes large, the output of light emitted by the red LED 4a becomes large. Thus, as compared with the case before the rise of temperature, the degree that the ratio of the red LED 4a becomes small is reduced, or the output balance is not changed. In other words, the change of the output balance of the lights outputted by the respective plural kinds of light-emitting elements can be suppressed.

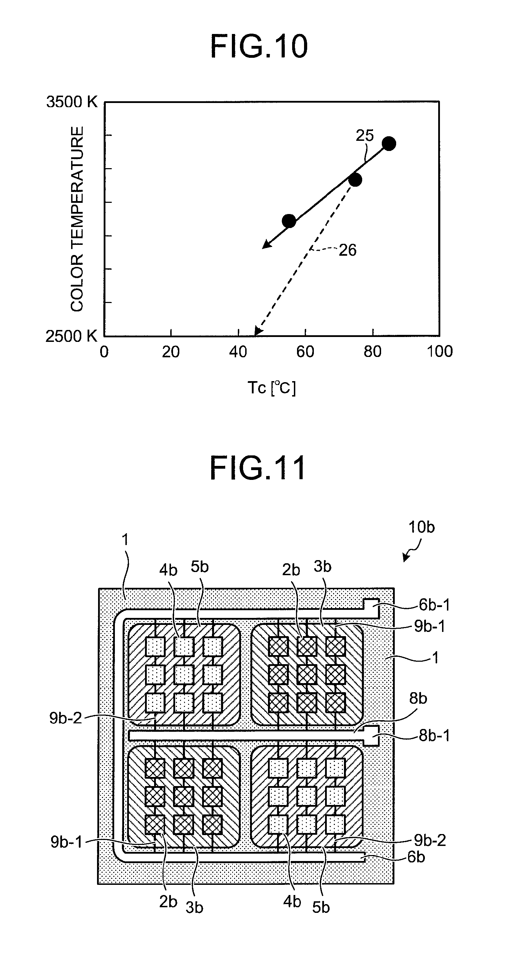

FIG. 10 is a view showing an example of a relation between color temperature and temperature in the circuit diagram shown in FIG. 8 and in the circuit diagram shown in FIG. 9. As shown in FIG. 10, in a relation 25 indicating the relation in FIG. 8, as compared with a relation 26 indicting the relation in FIG. 9, the rate of change of the color temperature with respect to the temperature change is small. In other words, it is understood that the change of the output balance of the lights outputted by the respective plural kinds of light-emitting elements is suppressed.

Besides, according to the first embodiment, the light-emitting efficiency and the voltage of the first light-emitting element and the second light-emitting element decrease with the rise of temperature, and increase with the lowering of temperature. As a result, the change of the output balance of the lights outputted by the respective plural kinds of light-emitting elements can be certainly suppressed.

Besides, according to the first embodiment, the first light-emitting element is a blue LED (Light Emitting Diode) element, and the second light-emitting element is a red LED. As a result, the change of the output balance of the lights outputted by the respective plural kinds of light-emitting elements can be certainly suppressed.

Besides, according to the first embodiment, the plural first light-emitting element groups exist in each of which the plural first light-emitting elements are connected in series, the plural second light-emitting element groups exist in each of which the plural second light-emitting elements are connected in series, and the plural first light-emitting element groups and the plural second light-emitting element groups are connected in parallel. As a result, the change of the output balance of the lights outputted by the respective plural kinds of light-emitting elements can be certainly suppressed.

Besides, according to the first embodiment, the first light-emitting element group in which the plural first light-emitting elements are connected in series, and the second light-emitting element group in which the plural second light-emitting elements are connected in series are connected in parallel, and the rated condition of the first light-emitting element group is equal to the rated condition of the second light-emitting element group. As a result, the change of the output balance of the lights outputted by the respective plural kinds of light-emitting elements can be more certainly suppressed.

### Second Embodiment

A second embodiment is different from the first embodiment in an arrangement form of LEDs. Since the other points are the same as the first embodiment, the description thereof will be omitted. FIG. 11 is a top view showing a light-emitting module of the second embodiment. FIG. 11 is the top view of the light-emitting module 10b of the second embodiment when viewed from the arrow A direction in FIG. 1.

As shown in FIG. 11, in the light-emitting module 10b, two first light-emitting element groups each including plural blue LEDs 2b are arranged on a diagonal line on a substrate 1. Besides, in the light-emitting module 10b, two second light-emitting element groups each including plural red LEDs 4b are arranged on a diagonal line on the substrate 1 symmetric to the arrangement of the first light-emitting element groups with respect to the center of the substrate 1.

The light-emitting module 10b includes, on the substrate 1, an electrode 6b-1 connected to an electrode junction part 14a-1 of a luminaire 100b and a wiring 6b extending from the electrode 6b-1. Besides, the light-emitting module 10b includes, on the substrate 1, a wiring 8b connected in parallel to the wiring 6b through the blue LEDs 2b connected in series by a bonding wire 9b-1 and the red LEDs 4b connected in series by a bonding wire 9b-2. The wiring 8b includes, at an extending tip, an electrode 8b-1 connected to an electrode junction part 14b-1 of the luminaire 100b. Incidentally, the blue LED 2b has similar thermal characteristics to the blue LED 2a of the first embodiment. Besides, the red LED 4b has similar thermal characteristics to the red LED 4a of the first embodiment.

When the blue LEDs 2b and the red LEDs 4b are arranged on the substrate 1 as shown in FIG. 11, first areas sealed with sealing parts 3b and second areas sealed with sealing parts 5b are located at positions point-symmetric with respect to the center of the substrate 1. Thus, in the light-emitting module 10b, lights emitted by the respective blue LEDs 2b and the respective red LEDs 4b are combined in a balanced manner, and the light having a desired light-emitting pattern, brightness or hue can be easily obtained.

### Third Embodiment

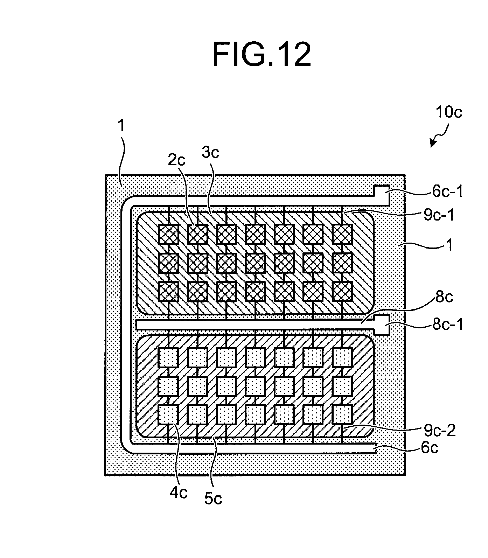

A third embodiment is different from the first embodiment and the second embodiment in an arrangement form of LEDs. Since the other points are same as the first embodiment and the second embodiment, the description thereof will be omitted. FIG. 12 is a top view showing a light-emitting module of the third embodiment. FIG. 12 is the top view of the light-emitting module 10c of the third embodiment when viewed from the arrow A direction in FIG. 1.

As shown in FIG. 12, in the light-emitting 10c, on a substrate 1, a first light-emitting element group including plural blue LEDs 2c is arranged in one of areas obtained by halving the substrate 1. Besides, in the light-emitting module 10c, on the substrate 1, a second light-emitting element group including plural red LEDs 4c is arranged in the other of the areas obtained by halving the substrate 1, in which the first light-emitting element group is not arranged.

The light-emitting module 10c includes, on the substrate 1, an electrode 6c-1 connected to an electrode junction part 14a-1 of a luminaire 100c, and a wiring 6c extending from the electrode 6c-1. Besides, the light-emitting module 10c includes, on the substrate 1, a wiring 8c connected in parallel to the wiring 6c through the plural blue LEDs 2c connected in series by a bonding wire 9c-1 and the plural red LEDs 4c connected in series by a bonding wire 9c-2. The wiring 8c includes, at an extending tip, an electrode 8c-1 connected to an electrode junction part 14b-1 of the luminaire 100c. Incidentally, the blue LED 2c has similar thermal characteristics to the blue LED 2a of the first embodiment. Besides, the red LED 4c has similar thermal characteristics to the red LED 4a of the first embodiment.

As shown in FIG. 12, the blue LEDs 2c and the red LEDs 4c are collected on the substrate 1, and a first area sealed with a sealing part 3c and a second area sealed with a sealing part 5c are separately formed. Thus, a control part 14 of the luminaire 100c can easily perform drive control and heat management of the respective blue LEDs 2c and the respective red LEDs 4c. Thus, the light-emitting module 10c suppresses the deterioration of the whole light-emitting characteristics due to the deterioration of the light-emitting characteristics of the red LEDs 4c caused by heat.

### Other Embodiments

For example, in the above embodiments, the blue LED 2a to 2c is the first light-emitting element, and the red LED 4a to 4c is the second light-emitting element. However, no limitation is made to this, and any light-emitting elements may be adopted irrespective of the light-emitting color as long as the first light-emitting element and the second light-emitting element having thermal characteristics inferior to the first light-emitting element are combined. Besides, in the above embodiments, materials of the sealing part 3a-3c and the sealing part 5a-5c are different from each other, and the refractive indexes are different. However, no limitation is made to this, and the sealing part 3a-3c and the sealing part 5a-5c may have the same material. Besides, the sealing method of the blue LEDs 2a-2c and the red LEDs 4a-4c by the sealing part 3a-3c and the sealing part 5a-5c is not limited to the method described in the embodiments, and various methods may be used.

Although exemplary embodiments have been described, these embodiments have been presented by way of example only, and are not intended to limit the scope of the invention. Indeed, these novel embodiments can be carried out in a variety of other forms, and various omissions, substitutions and changes can be made within the scope not departing from the gist of the invention. These embodiments and modifications thereof fall within the scope and the gist of the invention and fall within the scope of the invention recited in the claims and their equivalents.

## Claims

1. A light-emitting module (10a-10c) comprising:
a first light-emitting element group having first light-emitting elements (2a) which are connected in series; and
a second light-emitting element group connected in parallel to the first light-emitting element group and having second light-emitting elements (4a) which are connected in series, the second light-emitting elements having a larger rate of change in light-emitting efficiency and rate of change in voltage with respect to a given temperature change than the first light-emitting elements (2a).

2. The light-emitting module (10a-10c) according to claim 1, wherein
the first light-emitting element group and the second light-emitting element group connected in parallel are connected to a common power supply path, and
when a temperature change occurs in the respective light-emitting element groups during lighting, a total amount of power supplied to the respective light-emitting element groups is not changed, while values of currents flowing through the respective light-emitting element groups are changed.

3. The light-emitting module (10a-10c) according to claim 1 or 2, wherein the light-emitting efficiency and the voltage of the first light-emitting element (2a) and the second light-emitting element (4a) decrease with a rise of the temperature and increase with a lowering of the temperature.

4. The light-emitting module (10a-10c) according to any one of claims 1 to 3, wherein
the first light-emitting element (2a) is a blue LED (light emitting diode) element, and
the second light-emitting element (4a) is a red LED element.

5. The light-emitting module (10a-10c) according to any one of claims 1 to 4, wherein a rated condition of the first light-emitting element group is equal to a rated condition of the second light-emitting element group.

6. The light-emitting module (10a-10c) according to any one of claims 1 to 5, wherein
a plurality of the first light-emitting element groups are provided,
a plurality of the second light-emitting element groups are provided, and
the plurality of the first light-emitting element groups are connected in parallel to the plurality of the second light-emitting element groups.

7. A luminaire (100a-100c) comprising:
a main body (11);
a substrate (1) housed within the main body (11);
a first light-emitting element group mounted on the substrate (1) and having first light-emitting elements (2a) which are connected in series; and
a second light-emitting element group mounted on the substrate (1) and connected in parallel to the first light-emitting element group, the second light-emitting element group having second light-emitting elements (4a) which are connected in series the second light-emitting elements having a larger, the second light-emitting elements (4a) having a larger rate of change in light-emitting efficiency and rate of change in voltage with respect to a temperature change than the first light-emitting elements (2a).

8. The luminaire (100a-100c) according to claim 7, wherein
the first light-emitting element group and the second light-emitting element group connected in parallel are connected to a common power supply path, and
when a temperature change occurs in the respective light-emitting element groups during lighting, a total amount of power supplied to the respective light-emitting element groups is not changed, while values of currents flowing through the respective light-emitting element groups are changed.

9. The luminaire (100a-100c) according to claim 7 or 8, wherein
the light-emitting efficiency and the voltage of the first light-emitting element (2a) and
the second light-emitting element (4a) decrease with a rise of the temperature and increase with a lowering of the temperature.

10. The luminaire (100a-100c) according to any one of claims 7 to 9, wherein the first light-emitting element (2a) is a blue LED (ligh emitting diode) element, and the second light-emitting element (4a) is a red LED element.

11. The luminaire (100a-100c) according to any one of claims 7 to 10, wherein a rated condition of the first light-emitting element group is equal to a rated condition of the second light-emitting element group.

12. The luminaire (100a-100c) according to any one of claims 7 to 11, wherein
a plurality of the first light-emitting element groups are provided,
a plurality of the second light-emitting element groups are provided, and
the plurality of the first light-emitting element groups are connected in parallel to the plurality of the second light-emitting element groups.
